# EUROPÄISCHE PATENTSCHRIFT

(11) **EP 4 622 107 B1**
(45) Veröffentlichungstag und Bekanntmachung des Hinweises auf die Patenterteilung: **19.08.2026**
(21) Anmeldenummer: 24164997.9
(22) Anmeldetag: 21.03.2024
(51) Int. Cl.: H03K 17/975, G06F 3/039, G06F 3/0362

(54) **SCHALTER ZUR BETÄTIGUNG EINES KAPAZITIVEN TOUCHDISPLAYS**
SWITCH FOR ACTUATING A CAPACITIVE TOUCH DISPLAY
COMMUTATEUR POUR ACTIONNER UN ÉCRAN TACTILE CAPACITIF

(43) Veröffentlichungstag der Anmeldung: 24.09.2025
(73) Patentinhaber: ddm hopt + schuler GmbH & Co. KG, 78628 Rottweil (DE)
(72) Erfinder: HOPT, Karl-Rudolf, D-78628 Rottweil (DE); RULLO, Sascha, D-78628 Rottweil (DE)
(74) Vertreter: Kohler Schmid Möbus Patentanwälte

(56) Entgegenhaltungen:
- EP-A1- 3 617 854
- DE-A1- 102018 127 494
- DE-A1- 102022 107 450
- DE-T5- 112015 006 440

## Beschreibung

Die vorliegende Erfindung betrifft einen Dreh-/Drück-Schalter (Encoder) zur Betätigung eines kapazitiven Touchdisplays.

Derartige Dreh-/Drück-Schalter sind beispielsweise durch DE 11 2015 006 440 T5, DE 11 2017 008 192 T5, DE 10 2018 127 494 A1, DE 10 2022 107 450 A1 und EP 3 617 854 A1 bekannt geworden.

Demgegenüber besteht die Aufgabe der vorliegenden Erfindung darin, einen alternativen, aus möglichst wenigen Einzelteilen aufgebauten Dreh-/Drück-Schalter anzugeben.

Diese Aufgabe wird erfindungsgemäß durch einen Schalter mit den Merkmalen von Anspruch 1 gelöst.

Erfindungsgemäß wird durch manuelles Drehen des Schaltknopfes der Rotor samt der zweiten Kontaktfläche gedreht, was vom Touchdisplay aufgrund des geringen Abstands zwischen der zweiten Kontaktfläche und dem Touchdisplay kapazitiv detektiert wird. In der oberen Endstellung des Schaltknopfes ist die erste Kontaktfläche hingegen weit genug vom Touchdisplay beabstandet und kann daher von diesem nicht kapazitiv detektiert werden. Das Herunterdrücken des Schaltknopfs in die untere Endstellung führt dazu, dass die erste Kontaktfläche nun ausreichend nah zum Touchdisplay beabstandet ist und daher von diesem kapazitiv detektiert werden kann. In der zentralen Rotoröffnung ist das untere Zapfenende des Achszapfens, unter Ausbildung einer elektrisch leitenden (Schleif)Verbindung mit dem Rotor, axial verschiebbar geführt und unverdrehbar gehalten.

Vorzugsweise befindet sich die erste Kontaktfläche in der unteren Endstellung des Achszapfens auf der axialen Höhe der zweiten Kontaktfläche. Damit die Kontaktflächen vom Touchdisplay kapazitiv detektiert werden, sind die erste Kontaktfläche in der unteren Endstellung des Achszapfens und/oder die zweite Kontaktfläche von der Befestigungsebene geringfügig, nämlich jeweils um weniger als 0,2 mm, beabstandet. Um ein Verkratzen des Touchdisplays durch die Kontaktflächen auszuschließen, sind die erste Kontaktfläche in der unteren Endstellung des Achszapfens und/oder die zweite Kontaktfläche von der Befestigungsebene zwischen ca. 0,05 und ca. 0,1 mm beabstandet.

Bevorzugt liegt in der oberen Endstellung des Achszapfens das untere Zapfenende an einem nach unten weisenden Absatz der Rotoröffnung an. Alternativ kann auch der Stator einen Anschlag aufweisen, an dem der Schaltknopf in der oberen Endstellung anliegt.

Besonders bevorzugt ist die Rotoröffnung gestuft mit einer oberen Öffnung und mit einer sich daran unten anschließenden, größeren, unteren Öffnung mit nicht-kreisrundem Öffnungsquerschnitt ausgebildet, und das untere Zapfenende weist einen unteren Zapfenabschnitt mit nicht-kreisrundem Zapfenquerschnitt auf, der in der unteren Öffnung, unter Ausbildung einer elektrisch leitenden (Schleif)Verbindung mit dem Rotor, axial verschiebbar geführt und unverdrehbar gehalten ist. Dabei können der nicht-kreisrunde Öffnungsquerschnitt der unteren Öffnung und der nicht-kreisrunde Zapfenquerschnitt des unteren Zapfenabschnitts formschlüssig ineinandergreifen und insbesondere komplementäre Querschnitte aufweisen.

Der Achszapfen kann einteilig oder mehrteilig ausgebildet sein. Für einen einfachen

Zusammenbau weist der Achszapfen vorzugsweise ein oberes Zapfenteil, welches in der Lageröffnung drehbar gelagert und axial verschiebbar geführt ist, und ein separates unteres Zapfenteil auf, welches am oberen Zapfenteil befestigt ist und das untere Zapfenende ausbildet. Besonders vorteilhaft sind die beiden Zapfenteile miteinander steckverbunden und, insbesondere mittels Klebung oder Presspassung, aneinander fixiert.

Die Erfindung betrifft auch eine Anordnung mit einem kapazitiven Touchdisplay und mit einem wie oben ausgebildeten Schalter, dessen Stator auf dem Touchdisplay ortsfest befestigt ist. Dabei kann der Stator beispielsweise auf dem Touchdisplay ortsfest fixiert sein, insbesondere festgeklebt sein, oder unverdrehbar an einem Haltering, welcher auf dem Touchdisplay ortsfest fixiert ist, insbesondere festgeklebt ist, magnetisch gehalten sein. Im letzteren Fall ist der Schalter vom Haltering bzw. vom Touchdisplay abnehmbar.

Weitere Vorteile der Erfindung ergeben sich aus der Beschreibung, den Ansprüchen und der Zeichnung. Ebenso können die vorstehend genannten und die noch weiter aufgeführten Merkmale je für sich oder zu mehreren in beliebigen Kombinationen Verwendung finden, die jedoch nicht als Teil der Erfindung zu verstehen sind. Die Erfindung ist lediglich in den Ansprüchen definiert. Die gezeigte und beschriebene Ausführungsform ist nicht als abschließende Aufzählung zu verstehen, sondern hat vielmehr beispielhaften Charakter für die Schilderung der Erfindung.

Es zeigen:
- Fig. 1: den auf einem Touchdisplay befestigten erfindungsgemäßen Schalter in einem Längsschnitt;
- Fign. 2a, 2b: den erfindungsgemäßen Schalter ohne einen in Fig. 1 gezeigten Stator in einer perspektivischen Schnittansicht (Fig. 2a) und in einem Längsschnitt (Fig. 2b);
- Fign. 3a-3c: ein in Fign. 1 und 2 gezeigtes unteres Zapfenteil und einen in Fign. 1 und 2 gezeigten Rotor in einer perspektivischen Ansicht von oben (Fig. 3a), einer Seitenansicht (Fig. 3b) und einer perspektivischen Ansicht von unten (Fig. 3c);
- Fign. 4a, 4b: den in Fig. 3 gezeigten Rotor in einer perspektivischen Ansicht von oben (Fig. 4a) und von unten (Fig. 4b);
- Fig. 5: das in Fig. 3 gezeigte untere Zapfenteil in einer Seitenansicht;
- Fig. 6: einen magnetischen Haltering zur magnetischen Befestigung des erfindungsgemäßen Schalters auf dem Touchdisplay; und
- Fig. 7: eine Gitterstruktur des Touchdisplays.

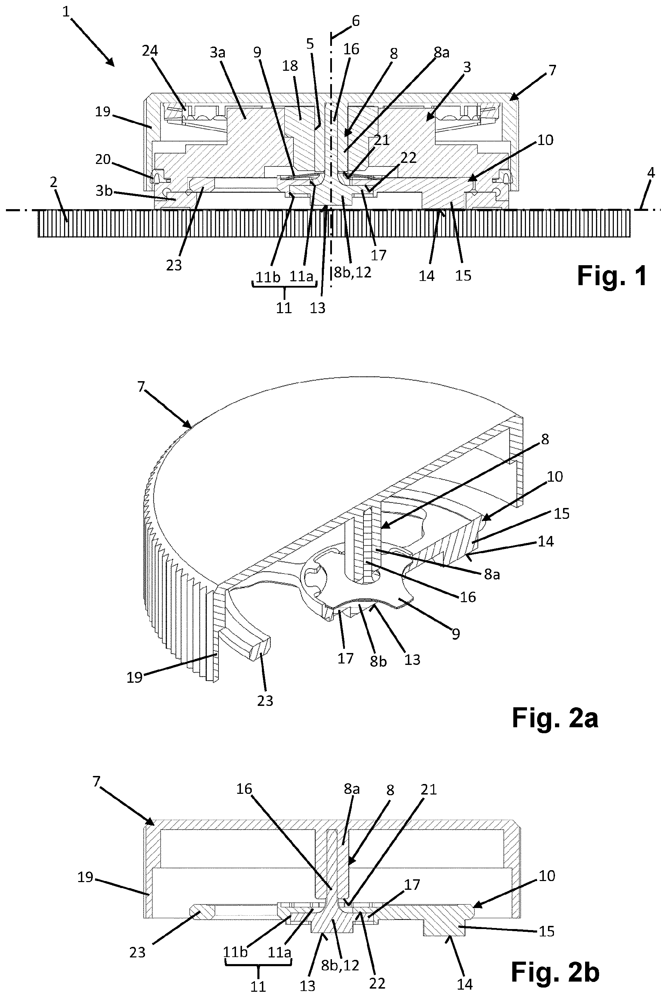

Der in Fig. 1 gezeigte Schalter **1** ist auf einem kapazitiven Touchdisplay **2** ortsfest befestigt und dient zur Betätigung des Touchdisplays 2.

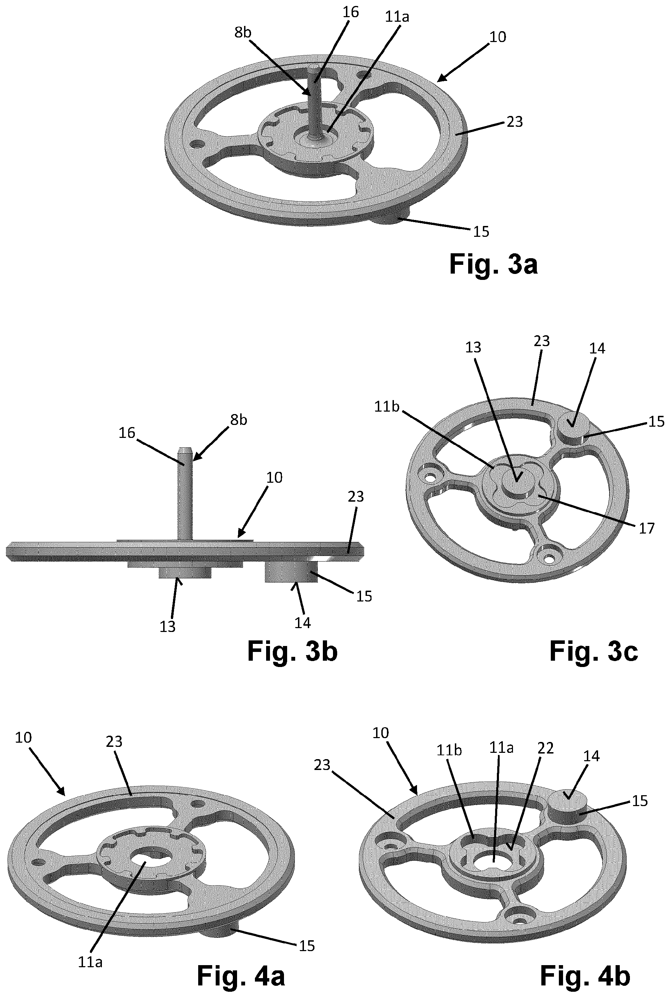

Wie in Fign. 1 bis 5 gezeigt, weist der Schalter 1 folgende Komponenten auf:
- einen Stator **3** mit einer Statorunterseite, welche eine Befestigungsebene **4** zur Befestigung auf dem Touchdisplay 2 definiert, und mit einer Lageröffnung **5,** welche eine zur Befestigungsebene rechtwinklige Drehachse **6** definiert;
- einen auf dem Stator 3 angeordneten Schaltknopf **7** aus elektrisch leitendem Material, der mit einem nach unten stehenden Achszapfen **8** in der Lageröffnung 5 sowohl um die Drehachse 6 drehbar gelagert als auch aus einer oberen Endstellung gegen die Wirkung einer Rückstellkraft, hier mittels einer Schnappscheibe **9,** in eine untere Endstellung axial verschiebbar geführt ist; und
- einen unterseitig im Stator 3 angeordneten Rotor **10** aus elektrisch leitendem Material, der im Stator 3 zwischen einem Statoroberteil **3a** und einem Statorunterteil **3b** axial unverschiebbar angeordnet und um die Drehachse 6 drehbar gelagert ist und eine gestufte, zentrale Rotoröffnung **11** aufweist, in welcher ein aus der Lageröffnung 5 nach unten vorstehendes Zapfenende **12** des Achszapfens 8 - unter Ausbildung einer elektrisch leitenden (Schleif)Verbindung mit dem Rotor 10 - axial verschiebbar geführt und unverdrehbar gehalten ist.

Das untere Zapfenende 12 weist unterseitig eine elektrisch leitend mit dem Schaltknopf 7 verbundene, erste Kontaktfläche (Pushpad) **13** auf, die sich in der unteren Endstellung des Achszapfens 8 geringfügig, bevorzugt zwischen ca. 0,05 mm und ca. 0,1 mm, oberhalb der Befestigungsebene 4 befindet. Der Rotor 10 weist eine exzentrisch zur Drehachse 6 angeordnete, elektrisch leitend mit dem Schaltknopf 7 verbundene, zweite Kontaktfläche (Drehpad) **14** auf, die sich geringfügig, bevorzugt zwischen ca. 0,05 mm und ca. 0,1 mm, oberhalb der Befestigungsebene 4 befindet. Vorzugsweise befindet sich die erste Kontaktfläche 14 in der unteren Endstellung des Achszapfens 8 auf der axialen Höhe der zweiten Kontaktfläche 14. Wie gezeigt, kann die zweite Kontaktfläche 14 unterseitig an einem exzentrisch zur Drehachse 6 angeordneten, axial nach unten stehenden Rotorvorsprung **15** ausgebildet sein.

Der Achszapfen 8 kann einteilig oder mehrteilig ausgebildet sein. Wie in Fig. 1 gezeigt, ist der Achszapfen 8 vorliegend zweiteilig ausgebildet, und zwar mit einem am Schaltknopf 7 angeformten, oberen Zapfenteil **8a,** welches in der Lageröffnung 5 drehbar gelagert und axial verschiebbar geführt ist, und mit einem separaten unteren Zapfenteil **8b** aus elektrisch leitendem Material, welches am oberen Zapfenteil 8a - unter Ausbildung einer elektrisch leitenden Verbindung mit dem oberen Zapfenteil 8a - befestigt ist und das untere Zapfenende 12 ausbildet. Das untere Zapfenteil 8b ist beispielsweise mit einem schmalen Schaft **16** in eine axial nach unten offene, zentrale Öffnung des oberen Zapfenteils 8a eingesteckt und darin mittels Klebung oder Presspassung fixiert.

Die Rotoröffnung 11 ist gestuft mit einer hier kreisrunden, oberen Öffnung **11a** und mit einer sich daran unten anschließenden, demgegenüber größeren, unteren Öffnung **11b** mit nicht-kreisrundem Öffnungsquerschnitt ausgebildet. Das untere Zapfenende 12 durchgreift mit seinem schmalen Schaft 16 die obere Öffnung 11a und weist weiter unten einen verbreiterten, unteren Zapfenabschnitt **17** mit nicht-kreisrundem Zapfenquerschnitt auf, der in der unteren Öffnung 11b, unter Ausbildung einer elektrisch leitenden (Schleif)Verbindung mit dem Rotor 10, axial verschiebbar geführt und unverdrehbar gehalten ist. Vorzugsweise greifen der nicht-kreisrunde Öffnungsquerschnitt der unteren Öffnung 11b und der nicht-kreisrunde Zapfenquerschnitt des unteren Zapfenabschnitts 17 komplementäre Querschnitte auf, die formschlüssig ineinandergreifen. Vorliegend weisen die komplementären Querschnitte jeweils eine wellenförmige Öffnungskontur mit vierzähliger Drehsymmetrie auf.

Die Lageröffnung 5 kann, wie gezeigt, durch eine Führungshülse **18** gebildet sein, die in einer zentralen Statoröffnung des Statoroberteils 3a, insbesondere mittels Klebung oder Presspassung, fixiert ist. Der nach unten offene Schaltkopf 7 umgreift das Statoroberteil 3a radial außen mit einer Umfangswand **19,** die mittels eines im Statoroberteil 3a eingelegten Radialwellendichtrings **20** gegen das Statoroberteil 3a abgedichtet ist. Die Schnappscheibe 9 ist einerseits oberseitig auf dem Rotor 10 und andererseits an einem nach unten weisenden Absatz **21** des Achszapfens 8, hier an der unteren Stirnseite des oberen Zapfenteils 8a, abgestützt, um den Achszapfen 8 nach oben in seine in Fig. 1 gezeigte, obere Endstellung vorzuspannen. In dieser oberen Endstellung des Achszapfens 8 liegt das untere Zapfenende 12 mit seinem unteren Zapfenabschnitt 17 an einem Stufenabsatz **22** des Rotors 10 an, welcher zwischen den beiden Öffnungen 11a, 11b vorhanden ist.

Der Rotor 10 weist einen Außenring **23** auf, der im Stator 3 zwischen Statoroberteil 3a und Statorunterteil 3b axial unverschiebbar angeordnet ist. Weiter wirkt zwischen Schaltknopf 7 und Statoroberteil 3b eine Drehrastung **24,** die den Schaltknopf 7 in mehreren Drehpositionen, z.B. in 24 oder 32 Drehpositionen, jeweils lösbar verrastet. Die Drehrastung 24 kann beispielsweise innen im Schaltknopf 7 mehrere in Umfangsrichtung äquidistant angeordnete, nach unten offene Rastmulden und oben am Statoroberteil 3b mindestens einen hochstehenden Rastvorsprung aufweisen, der in den mehreren Drehpositionen jeweils in einer der Rastmulden verrastet ist, oder umgekehrt.

Statt der gezeigten einen zweiten Kontaktfläche 14 kann der Rotor 10 alternativ auch mehrere exzentrisch zur Drehachse 6 angeordnete, elektrisch leitend mit dem Schaltknopf 7 verbundene, zweite Kontaktflächen (Drehpads) 14 aufweisen.

In Fig. 1 ist das Statorunterteil 3b auf dem Touchdisplay 2 (z.B. mittels Klebstoff oder Klebepad) festgeklebt und dadurch der Schalter 1 auf dem Touchdisplay 2 ortsfest befestigt. Der Schalter 1 dient als HMI (Human Machine Interface)-Element auf dem Touch Display, wobei die erste und die zweite Kontaktfläche 13, 14 die Berührung eines menschlichen Fingers auf dem Touchdisplay 2 simulieren. Durch manuelles Drehen des Schaltknopfs 7 wird der Rotor 10 samt der zweiten Kontaktfläche 14 gedreht, was vom Touchdisplay 2 aufgrund des geringen Abstands zwischen der zweiten Kontaktfläche 14 und dem Touchdisplay 2 kapazitiv detektiert wird. In der oberen Endstellung des Schaltknopfs 7 ist die erste Kontaktfläche 13 weit genug vom Touchdisplay 2 beabstandet und kann daher von diesem nicht kapazitiv detektiert werden. Das Herunterdrücken des Schaltknopfs 7 in die untere Endstellung führt dazu, dass die erste Kontaktfläche 13 nun ausreichend nah zum Touchdisplay 2 beabstandet ist und daher von diesem kapazitiv detektiert werden kann. Beispielsweise kann durch Drehen des Schaltknopfs 7 ein Parameterwert (z.B. Soll-Temperatur oder Soll-Lautstärke) eingestellt werden, der dann durch Drücken des Schaltknopfes 7 bestätigt wird.

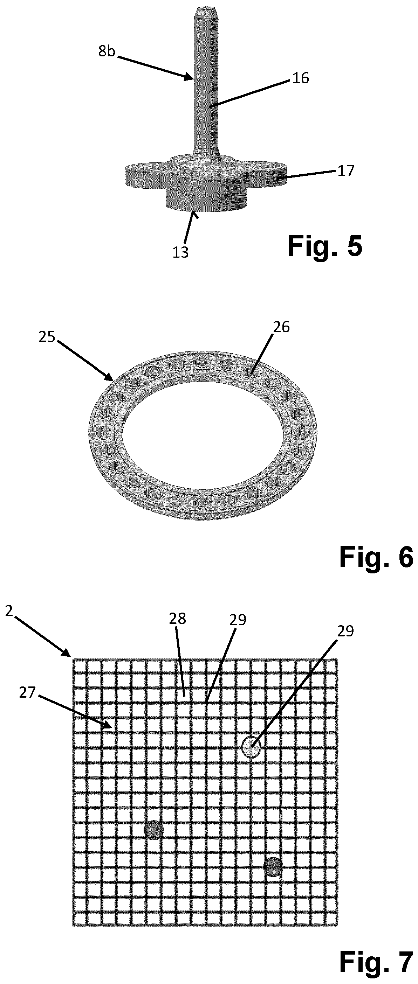

Alternativ zum direkten Fixieren des Stators 3 auf dem Touchdisplay 2 kann der Stator 3 auch mit Hilfe eines magnetischen Halterings **25** (Fig. 6), welcher auf dem Touchdisplay 2 ortsfest fixiert, insbesondere festgeklebt ist, magnetisch gehalten und dadurch auch abnehmbar sein. Der Haltering 25 weist einen oder mehrere Magnete (nicht gezeigt) zum magnetischen Anziehen des Stators 3 sowie unterseitig mehrere in Umgangsrichtung äquidistant angeordnete Aussparungen **26** zur Aufnahme von Klebstoff auf.

Es hat sich gezeigt, dass es sehr wichtig ist, wo genau der Schalter 1 auf dem Touchdisplay 2 befestigt wird. Wie in Fig. 7 schematisch gezeigt, wird das Touchdisplay 2 von einem Touch Controller in ein Raster **27** mit quadratischen Feldern **28** unterteilt, wobei die Kreuzungspunkte **29** des Rasters 27 auch als Knoten (nodes) bezeichnet werden. Im Optimalfall wird der Schalter 1 mit seiner Drehachse 6 genau in einem Kreuzungspunkt 29 auf dem Touchdisplay 2 befestigt, wie durch den hellen Kreis angedeutet ist. Diese Schalterposition ergibt im Vergleich zu anderen, mit dunklen Kreisen angedeuteten Schalterposition im Zentrum eines Feldes 28 oder zwischen zwei Feldern 28 ein sehr viel stärkeres Signal auf dem Touchdisplay 2.

## Patentansprüche

1. Schalter (1) zur Betätigung eines kapazitiven Touchdisplays (2), aufweisend
- einen Stator (3) mit einer Statorunterseite, welche eine Befestigungsebene (4) zur Befestigung auf dem Touchdisplay (2) definiert, und mit einer LagerÖffnung (5), welche eine zur Befestigungsebene rechtwinklige Drehachse (6) definiert,
- einen auf dem Stator (3) angeordneten Schaltknopf (7) aus elektrisch leitendem Material, der mit einem nach unten stehenden Achszapfen (8) in der Lageröffnung (5) sowohl um die Drehachse (6) drehbar gelagert als auch aus einer oberen Endstellung gegen die Wirkung einer Rückstellkraft in eine untere Endstellung axial verschiebbar geführt ist, und
- einen unterseitig im Stator (3) angeordneten Rotor (10) aus elektrisch leitendem Material, der im Stator (3) axial unverschiebbar angeordnet und um die Drehachse (6) drehbar gelagert ist und eine zentrale Rotoröffnung (11) aufweist, in welcher ein aus der Lageröffnung (5) nach unten vorstehendes, unteres Zapfenende (12) des Achszapfens (8), unter Ausbildung einer elektrisch leitenden Verbindung mit dem Rotor (10), axial verschiebbar geführt und unverdrehbar gehalten ist,
wobei das untere Zapfenende (12) unterseitig eine elektrisch leitend mit dem Schaltknopf (7) verbundene, erste Kontaktfläche (13) aufweist, die sich in der unteren Endstellung des Achszapfens (8) in oder oberhalb der Befestigungsebene (4) befindet, und wobei der Rotor (10) mindestens eine exzentrisch zur Drehachse (6) angeordnete, elektrisch leitend mit dem Schaltknopf (7) verbundene, zweite Kontaktfläche (14) aufweist, die sich in oder oberhalb der Befestigungsebene (4) befindet.

2. Schalter nach Anspruch 1, **dadurch gekennzeichnet, dass** sich die erste Kontaktfläche (13) in der unteren Endstellung des Achszapfens (8) auf der axialen Höhe der zweiten Kontaktfläche (14) befindet.

3. Schalter nach Anspruch 1 oder 2, **dadurch gekennzeichnet, dass** die erste Kontaktfläche (13) in der unteren Endstellung des Achszapfens (8) und/oder die zweite Kontaktfläche (14) von der Befestigungsebene (4) jeweils um weniger als 0,2 mm, insbesondere zwischen ca. 0,05 und ca. 0,1 mm, beabstandet sind.

4. Schalter nach einem der vorhergehenden Ansprüche, **dadurch gekennzeichnet, dass** die Lageröffnung (5) durch eine Führungshülse (18) gebildet ist, die in einer Statoröffnung des Stators (3), insbesondere mittels Klebung oder Presspassung, fixiert ist.

5. Schalter nach einem der vorhergehenden Ansprüche, **dadurch gekennzeichnet, dass** in der oberen Endstellung des Achszapfens (8) das untere Zapfenende (12) an einem nach unten weisenden Absatz (22) der Rotoröffnung (11) anliegt.

6. Schalter nach einem der vorhergehenden Ansprüche, **dadurch gekennzeichnet, dass** die Rotoröffnung (11) gestuft mit einer oberen Öffnung (11a) und mit einer sich daran unten anschließenden, größeren, unteren Öffnung (11b) mit nicht-kreisrundem Öffnungsquerschnitt ausgebildet ist und dass das untere Zapfenende (12) einen unteren Zapfenabschnitt (17) mit nicht-kreisrundem Zapfenquerschnitt aufweist, der in der unteren Öffnung (11b), unter Ausbildung einer elektrisch leitenden Verbindung mit dem Rotor (10), axial verschiebbar geführt und unverdrehbar gehalten ist.

7. Schalter nach Anspruch 6, **dadurch gekennzeichnet, dass** der nicht-kreisrunde Öffnungsquerschnitt der unteren Öffnung (11b) und der nicht-kreisrunde Zapfenquerschnitt des unteren Zapfenabschnitts (17) formschlüssig ineinandergreifen und insbesondere komplementäre Querschnitte aufweisen.

8. Schalter nach einem der vorhergehenden Ansprüche, **dadurch gekennzeichnet, dass** der Achszapfen (8) ein oberes Zapfenteil (8a), welches in der LagerÖffnung (5) drehbar gelagert und axial verschiebbar geführt ist, und ein separates unteres Zapfenteil (8b) aufweist, welches am oberen Zapfenteil (8a) befestigt ist und das untere Zapfenende (12) ausbildet.

9. Schalter nach Anspruch 8, **dadurch gekennzeichnet, dass** die beiden Zapfenteile (8a, 8b) miteinander steckverbunden und, insbesondere mittels Klebung oder Presspassung, aneinander fixiert sind.

10. Schalter nach einem der vorhergehenden Ansprüche, **dadurch gekennzeichnet, dass** die Rückstellkraft durch eine Druckfeder, insbesondere eine Schnappscheibe (9), gebildet ist.

11. Schalter nach Anspruch 10, **dadurch gekennzeichnet, dass** die Druckfeder einerseits am Rotor (10) und andererseits am Achszapfen (8), insbesondere an einem nach unten weisenden Absatz (22) des Achszapfens (8), abgestützt ist, um den Achszapfen (8) axial nach oben in seine obere Endstellung vorzuspannen.

12. Schalter nach einem der vorhergehenden Ansprüche, **dadurch gekennzeichnet, dass** der Rotor (10), insbesondere im Außenring (23) des Rotors (10), im Stator (3) zwischen einem Statoroberteil (3a) und einem Statorunterteil (3b) axial unverschiebbar angeordnet ist.

13. Schalter nach einem der vorhergehenden Ansprüche, **dadurch gekennzeichnet, dass** zwischen dem Stator (3) und dem Schaltknopf (7) eine Drehrastung (24) angeordnet ist, die den Schaltknopf (7) in mehreren Drehpositionen jeweils lösbar verrastet.

14. Anordnung mit einem kapazitiven Touchdisplay (2) und mit einem Schalter (1) nach einem der vorhergehenden Ansprüche, dessen Stator (3) auf dem Touchdisplay (2) ortsfest befestigt ist.

15. Anordnung nach Anspruch 14, **dadurch gekennzeichnet, dass** der Stator (3) auf dem Touchdisplay (2) ortsfest fixiert, insbesondere festgeklebt ist, oder unverdrehbar an einem Haltering (25), welcher auf dem Touchdisplay (2) ortsfest fixiert, insbesondere festgeklebt ist, magnetisch gehalten ist.

## Claims

1. A switch (1) for actuating a capacitive touch display (2), comprising
- a stator (3) with a stator lower side that defines a mounting plane (4) for attachment to the touch display (2), and with a bearing opening (5) that defines an axis of rotation (6) perpendicular to the mounting plane,
- a switch button (7) made of electrically conductive material and arranged on the stator (3), which is mounted in the bearing opening (5) via a downward-extending axle journal (8) such that it is both rotatable about the axis of rotation (6) and axially guided so that it can be displaced from an upper end position to a lower end position against the action of a restoring force, and
- a rotor (10) made of electrically conductive material and arranged on the lower side of the stator (3), which is arranged in the stator (3) so as to be axially non-displaceable and to be rotatable about the axis of rotation (6), and which has a central rotor opening (11), in which a lower end (12) of the axle journal (8), which projects downward from the bearing opening (5), is guided so as to be axially displaceable and held in a non-rotating manner, forming an electrically conductive connection with the rotor (10),
wherein the lower end (12) of the journal has, on its lower side, a first contact surface (13) which is connected to the switch button (7) in an electrically conducting manner and, in the lower end position of the axle journal (8), is located in or above the mounting plane (4), and wherein the rotor (10) has at least one second contact surface (14) which is arranged eccentrically with respect to the axis of rotation (6), is connected to the switch button (7) in an electrically conducting manner and is located in or above the mounting plane (4).

2. The switch according to claim 1, **characterized in that** the first contact surface (13) is located at the axial level of the second contact surface (14) when the axle journal (8) is in its lower end position.

3. The switch according to claim 1 or 2, **characterized in that** the first contact surface (13) in the lower end position of the axle journal (8) and/or the second contact surface (14) are each spaced from the mounting plane (4) by less than 0.2 mm, in particular between approximately 0.05 and approximately 0.1 mm.

4. The switch according to any of the preceding claims, **characterized in that** the bearing opening (5) is formed by a guide sleeve (18) that is fixed in a stator opening of the stator (3), in particular by adhesive bonding or press fit.

5. The switch according to any of the preceding claims, **characterized in that**, in the upper end position of the axle journal (8), the lower end (12) of the journal rests against a downward-facing shoulder (22) of the rotor opening (11).

6. The switch according to any of the preceding claims, **characterized in that** the rotor opening (11) is designed to be stepped, comprising an upper opening (11a) and a larger lower opening (11b) adjoining it at the bottom, with a non-circular opening cross-section, and **in that** the lower end (12) of the journal has a lower journal portion (17) with a non-circular journal cross-section, which is guided to be axially slidable within the lower opening (11b), forming an electrically conductive connection with the rotor (10), and is held in a non-rotatable manner.

7. The switch according to claim 6, **characterized in that** the non-circular opening cross-section of the lower opening (11b) and the non-circular cross-section of the lower journal portion (17) engage with each other in a form-fitting manner and, in particular, have complementary cross-sections.

8. The switch according to any one of the preceding claims, **characterized in that** the axle journal (8) comprises an upper journal portion (8a), which is rotatably mounted in the bearing opening (5) and is guided to be axially displaceable, and a separate lower journal portion (8b), which is attached to the upper journal portion (8a) and forms the lower journal end (12).

9. The switch according to claim 8, **characterized in that** the two journal portions (8a, 8b) are plug-connected to one another and fixed together, in particular by adhesive bonding or press fit.

10. The switch according to any one of the preceding claims, **characterized in that** the restoring force is provided by a pressure spring, in particular a snap disc (9).

11. The switch according to claim 10, **characterized in that** the pressure spring is supported on the one hand by the rotor (10) and on the other hand by the axle journal (8), in particular by a downward-facing shoulder (22) of the axle journal (8), in order to preload the axle journal (8) axially upward into its upper end position.

12. The switch according to any of the preceding claims, **characterized in that** the rotor (10), in particular in the outer ring (23) of the rotor (10), is arranged in the stator (3) between an upper part (3a) of the stator and a lower part (3b) of the stator such that it cannot be displaced axially.

13. The switch according to any of the preceding claims, **characterized in that** a rotational locking mechanism (24) is arranged between the stator (3) and the switch knob (7), which releasably locks the switch knob (7) in several rotational positions.

14. An assembly comprising a capacitive touch display (2) and a switch (1) according to any one of the preceding claims, the stator (3) of which is fixed in place on the touch display (2).

15. The assembly according to claim 14, **characterized in that** the stator (3) is fixed in place on the touch display (2), in particular, glued in place, or is held magnetically in a non-rotatable manner by a retaining ring (25), which is fixed in place on the touch display (2), in particular, glued in place.

## Revendications

1. Commutateur (1) pour l'activation d'un écran tactile capacitif (2), comprenant
- un stator (3) avec une face inférieure du stator, laquelle définit un plan de fixation (4) pour la fixation sur l'écran tactile capacitif (2), et avec une ouverture de palier (5), laquelle définit un axe de rotation (6) perpendiculaire au plan de fixation,
- un bouton de commutation (7) disposé sur le stator (3), en matériau électriquement conducteur, qui est monté avec un pivot d'axe (8) orienté vers le bas dans l'ouverture de palier (5), à la fois rotatif autour de l'axe de rotation (6) et guidé axialement déplaçable d'une position extrême supérieure contre l'action d'une force de rappel vers une position extrême inférieure, et
- un rotor (10) disposé sur la face inférieure du stator (3), en matériau électriquement conducteur, qui est disposé axialement non déplaçable dans le stator (3) et monté rotatif autour de l'axe de rotation (6), et qui présente une ouverture du rotor centrale (11), dans laquelle une extrémité du pivot inférieure (12) du pivot d'axe (8), faisant saillie vers le bas depuis l'ouverture de palier (5), est guidée axialement déplaçable et maintenue sans rotation, tout en formant une connexion électriquement conductrice avec le rotor (10), où l'extrémité du pivot inférieure (12) présente sur sa face inférieure une première surface de contact (13) reliée électriquement au bouton de commutation (7), laquelle se trouve, dans la position extrême inférieure du pivot d'axe (8), dans ou au-dessus du plan de fixation (4), et où le rotor (10) présente au moins une deuxième surface de contact (14), disposée excentrée par rapport à l'axe de rotation (6) et reliée électriquement au bouton de commutation (7), laquelle se trouve dans ou au-dessus du plan de fixation (4).

2. Commutateur selon la revendication 1, **caractérisé en ce que** la première surface de contact (13) se trouve, dans la position extrême inférieure du pivot d'axe (8), à la hauteur axiale de la deuxième surface de contact (14).

3. Commutateur selon la revendication 1 ou 2, **caractérisé en ce que** la première surface de contact (13) dans la position extrême inférieure du pivot d'axe (8) et/ou la deuxième surface de contact (14) sont chacune espacées du plan de fixation (4) de moins de 0,2 mm, en particulier entre environ 0,05 et environ 0,1 mm.

4. Commutateur selon l'une des revendications précédentes, **caractérisé en ce que** l'ouverture de palier (5) est formée par une douille de guidage (18), qui est fixée dans une ouverture du stator du stator (3), en particulier par collage ou ajustement serré.

5. Commutateur selon l'une des revendications précédentes, **caractérisé en ce que**, dans la position extrême supérieure du pivot d'axe (8), l'extrémité du pivot inférieure (12) repose contre un épaulement (22) orienté vers le bas de l'ouverture du rotor (11).

6. Commutateur selon l'une des revendications précédentes, **caractérisé en ce que** l'ouverture du rotor (11) est étagée avec une ouverture supérieure (11a) et une ouverture inférieure (11b) plus grande, qui lui est adjacente en dessous, avec une section d'ouverture non circulaire, et **en ce que** l'extrémité du pivot inférieure (12) présente une section du pivot inférieure (17) avec une section du pivot non circulaire, qui est guidée axialement déplaçable et maintenue sans rotation dans l'ouverture inférieure (11b), tout en formant une connexion électriquement conductrice avec le rotor (10).

7. Commutateur selon la revendication 6, **caractérisé en ce que** la section d'ouverture non circulaire de l'ouverture inférieure (11b) et la section du pivot non circulaire de la section du pivot inférieure (17) s'engrènent à ajustement de forme et présentent en particulier des sections complémentaires.

8. Commutateur selon l'une des revendications précédentes, **caractérisé en ce que** le pivot d'axe (8) présente une partie de pivot supérieure (8a), qui est montée rotative et guidée axialement déplaçable dans l'ouverture de palier (5), et une partie de pivot inférieure séparée (8b), qui est fixée à la partie de pivot supérieure (8a) et forme l'extrémité du pivot inférieure (12).

9. Commutateur selon la revendication 8, **caractérisé en ce que** les deux parties de pivot (8a, 8b) sont assemblées par emboîtement et, en particulier par collage ou ajustement serré, fixées l'une à l'autre.

10. Commutateur selon l'une des revendications précédentes, **caractérisé en ce que** la force de rappel est formée par un ressort de compression, en particulier une rondelle-ressort (9).

11. Commutateur selon la revendication 10, **caractérisé en ce que** le ressort de compression est appuyé d'une part sur le rotor (10) et d'autre part sur le pivot d'axe (8), en particulier sur un épaulement (22) orienté vers le bas du pivot d'axe (8), afin de précontraindre le pivot d'axe (8) axialement vers le haut dans sa position extrême supérieure.

12. Commutateur selon l'une des revendications précédentes, **caractérisé en ce que** le rotor (10), en particulier dans la bague extérieure (23) du rotor (10), est disposé axialement non déplaçable dans le stator (3) entre une partie supérieure du stator (3a) et une partie inférieure du stator (3b).

13. Commutateur selon l'une des revendications précédentes, **caractérisé en ce qu'**un dispositif d'encliquetage rotatif (24) est disposé entre le stator (3) et le bouton de commutation (7), lequel encliquète de manière amovible le bouton de commutation (7) dans plusieurs positions de rotation.

14. Agencement avec un écran tactile capacitif (2) et avec un commutateur (1) selon l'une des revendications précédentes, dont le stator (3) est fixé de manière stationnaire sur l'écran tactile capacitif (2).

15. Agencement selon la revendication 14, **caractérisé en ce que** le stator (3) est fixé de manière stationnaire sur l'écran tactile capacitif (2), en particulier collé, ou maintenu sans rotation sur une bague de maintien (25), laquelle est fixée de manière stationnaire sur l'écran tactile capacitif (2), en particulier collée, et maintenu magnétiquement.
